# EUROPÄISCHE PATENTSCHRIFT

(11) **EP 1 831 422 B1**
(45) Veröffentlichungstag und Bekanntmachung des Hinweises auf die Patenterteilung: **10.02.2010**
(21) Anmeldenummer: 05826360.9
(22) Anmeldetag: 06.12.2005
(51) Int. Cl.: C23C 14/22, C23C 16/448

(54) **VORRICHTUNG ZUR TEMPERIERTEN AUFBEWAHRUNG EINES BEHÄLTERS**
DEVICE FOR THE TEMPERED STORAGE OF A CONTAINER
DISPOSITIF POUR LE STOCKAGE THERMOREGULE D'UN CONTENANT

(30) Priorität: 18.12.2004 DE 102004061095
(43) Veröffentlichungstag der Anmeldung: 12.09.2007
(73) Patentinhaber: AIXTRON AG, 52134 Herzogenrath (DE)
(72) Erfinder: REINHOLD, Markus, D-40721 Hilden (DE); STRAUCH, Gerhard, Karl, 52072 Aachen (DE)
(74) Vertreter: Grundmann, Dirk
(86) Internationale Anmeldenummer: PCT/EP2005/056519
(87) Internationale Veröffentlichungsnummer: WO 2006/063956

(56) Entgegenhaltungen:
- CH-A- 159 734
- DE-A1- 10 048 759
- DE-U- 1 927 201
- US-A1- 2005 000 428
- US-B1- 6 319 327

## Beschreibung

Die Erfindung betrifft eine Vorrichtung gemäß Gattungsbegriff des Anspruches 1.

Eine derartige Vorrichtung ist aus der US 6,319,327 B1 bekannt. Dort wird ein MOCVD-System zum Abscheiden von Tantaloxydschichten auf Halbleiteroberflächen beschrieben. Die dort beschriebene Vorrichtung besitzt ein Gehäuse zur temperierten Aufbewahrung eines Behälters zur Aufnahme einer Flüssigkeit. Diese soll durch Verdampfen mittels eines durch den Behälter geleiteten Trägergases aus dem Behälter transportiert werden.

Die Erfindung betrifft darüber hinaus eine Vorrichtung zum Abscheiden insbesondere organischer Schichten, bei dem in einem beheizten Reaktor ein in einer von einem Behälter gebildeten Quelle bevorrateter, nicht gasförmiger Ausgangsstoff mittels eines Trägergases im gasförmigen Zustand von der Quelle zu einem Substrat transportiert wird, wo er auf dem Substrat deponiert.

Aus der DE 100 48 759 ist eine Vorrichtung zur temperierten Aufbewahrung eines Behälters und eine Vorrichtung zum Abscheiden insbesondere organischer Schichten bekannt. Die Vorrichtung zur temperierten Aufbewahrung eines Behälters besitzt beheizbare Wände, die den Behälter auf einer insgesamt gleichen Temperatur halten sollen. Die in den Behälter einströmenden Gase werden beheizt. Die eingeströmten Gase durchströmen sich im Behälter befindende flüssige oder feste Stoffe, um diese als Gas in eine Vorrichtung abzutransportieren, in welcher diese gasförmigen Stoffe als Schicht auf einem Substrat kondensieren.

Im Stand der Technik sind darüber hinaus Hochtemperaturöfen bekannt, die im Bereich von 200 bis 800° C darin enthaltene Gegenstände auf einer konstanten Temperatur halten. Die Temperaturregelgenauigkeit umfasst aber nur einen Bereich von +/-3°. Im Innenraum kann die Temperatur lokal sogar in einem Bereich von +/-9° C variieren.

Die Organic Vapour Phase Deposition System (OVPD-Technologie) zur OLED-Displayherstellung als Alternative zu dem bekannten LCD-Displays erfordert bisher nicht erreichte Genauigkeitswerte bei der Steuerung der lokalen und zeitlichen Temperaturstabilität in der Temperaturkammer. Mittels der OVPD lassen sich nanometerdicke organische Filme auf festen Substraten abscheiden. Die organischen Materialien werden dabei in Quellen, die in Hochtemperaturöfen eingebaut sind, verdampft. Der Dampf in der Quelle wird mit einem Trägergas, wie z. B. Stickstoff in Form einer Gasmischung über eine Transportleitung in eine Depositionskammer geleitet. Dort kondensiert das organische Material auf einem gekühlten Substrat. Diese entstandene Schichtstruktur kann nach einigen weiteren Prozessschritten zu einem OLED-Display verarbeitet werden.

Eines der wichtigsten Ziele der OVPD ist es, zu jedem Zeitpunkt reproduzierbare dicke Filme abzuscheiden. Physikalisch bedeutet dies, dass idealerweise zu jedem Zeitpunkt die gleiche Materialmenge im Behälter in die Gasphase überführt wird, die sich dann in der Depositionskammer in identisch dicken Filmen niederschlägt.

Die physikalisch bestimmende Größe für diese Art der Verdampfung ist der Dampfdruck der in dem Behälter sich befindenden Komponente, welche flüssig oder fest sein kann. Je größer der Dampfdruck bei einer bestimmten Temperatur ist, desto mehr Material kann pro Zeit in die Gasphase überführt werden. Da der Dampfdruck eine exponentielle Funktion der Temperatur ist, wirken sich bereits kleine Temperaturunterschiede in erheblichem Umfang auf die ausgetragenen Menge an organischem Material aus. Das Ziel einer reproduzierbaren Filmdicke ist folglich nur über eine extreme zeitliche Stabilität und lokale Temperaturhomogenität erreichbar.

Der Erfindung liegt somit die Aufgabe zugrunde, die gattungsgemäße Vorrichtung hinsichtlich einer qualitativ höheren Abscheidung von organischen Schichten weiterzubilden.

Gelöst wird die Aufgabe durch die in den Ansprüchen angegebene Erfindung. Jeder Anspruch stellt grundsätzlich eine eigenständige Lösung dar, die auch unabhängig von weiteren Ansprüchen zur Lösung der Aufgabe beiträgt. Jeder Anspruch kann aber mit jedem anderen Anspruch kombiniert werden.

Der Anspruch 1 sieht zunächst und im Wesentlichen vor, dass in der Kammer ein Gasstromerzeuger und Gasstromleitmittel vorgesehen sind, die den vom Gasstromerzeuger erzeugten Gasstrom leiten. In der Kammer ist ein Gasstromerzeuger vorgesehen. Dieser erzeugt einen Gasstrom, der von den Gasstromleitmitteln geleitet wird. Letztere werden von den Wänden eines den Behälter aufnehmenden Innengehäuses ausgebildet, an denen der Gasstrom beidseitig und jeweils in entgegengesetzter Richtung vorbeiströmt. Das Gas kann Stickstoff oder ein anderes inertes Gas sein. Der Gasstromerzeuger kann ein Ventilator sein. Die Gasstromleitmittel können Bleche sein. Die Bleche sind vorzugsweise derartig ausgestaltet und angeordnet, dass sie den Gasstrom am Behälter vorbei und / oder an den Gehäusewänden vorbei leiten, so dass innerhalb des Gehäuses eine nahezu gleichbleibende und gleiche Temperatur gemessen werden kann. Die Temperaturstabilität kann im kontinuierlichen Betrieb +/-0,05° über einen Tag betragen. Der Temperaturgradient im Ofen ist minimal, so dass im gesamten Ofenbereich eine lokale Temperaturhomogenität von +/-2° C oder besser erreichbar ist. Die Ofentemperatur ist in Abhängigkeit der Heizleistung auf Temperaturen bis 700° C mit einer Genauigkeit von 0,1° C einstellbar. Die Gasstromleitmittel erzeugen im Ofen eine Konvektionsströmungsführung, die den Gasstrom durch den gesamten Ofen leitet, so dass alle Bereiche im Wesentlichen dieselbe Temperatur aufweisen. Über eine kontinuierliche Temperaturmessung im Innen- und Außenbereich des Ofens wird über einen elektronischen Regelungsalgorithmus die Konvektionsströmung im Außenbereich als lokal aktiver, justierbarer thermischer Isolator funktionalisiert. Im Innenbereich des Innengehäuses befindet sich der Behälter. Dieser wird auch von der von den Gasstromleitmitteln abgestrahlten Wärme temperiert. Hierzu haben die Oberflächen der Gasstromleitmittel eine besonders definierte Emissionsfähigkeit. Die aus Blechen bestehenden Gasstromleitmittel können eine dementsprechende Oberfläche aufweisen, die poliert oder rau aber bevorzugt auch absorbierend oder reflektierend ist. Das Innengehäuse ist vorzugsweise von der Innenwandung des Gehäuses beabstandet angeordnet, wobei es einen anwendungsspezifischen Abstand zur Gehäuseinnenwand aufweist. Der Gasstrom wird von einem Ventilator erzeugt, der sich vorteilhafterweise an der Decke des Gehäuses befindet. Er kann ein Radiallüfter sein, der den Gasstrom aus einer Öffnung der Decke des Innengehäuses saugt. Unterhalb der Decke kann ein Gitter angeordnet sein. Am Boden des Innengehäuses oder im Bereich der Seiten sowie oben befindet sich ein Heizregister, welches oberhalb einer bodenseitigen Öffnung des Innengehäuses angeordnet ist. Zusätzliche Heizregister können oben oder in den seitlichen Kanälen vorgesehen sein. Durch dieses Heizgitter strömt das an der Innenwandung des Gehäuses vorbeiströmende Gas und gelangt so in das Innengehäuse, in welchem sich der Behälter befindet. Der Gasstrom strömt am Behälter vorbei und verlässt diesen wieder durch die Deckenöffnung.

Ein Ausführungsbeispiel der Erfindung wird nachfolgend anhand beigefügter Zeichnungen erläutert. Es zeigen:

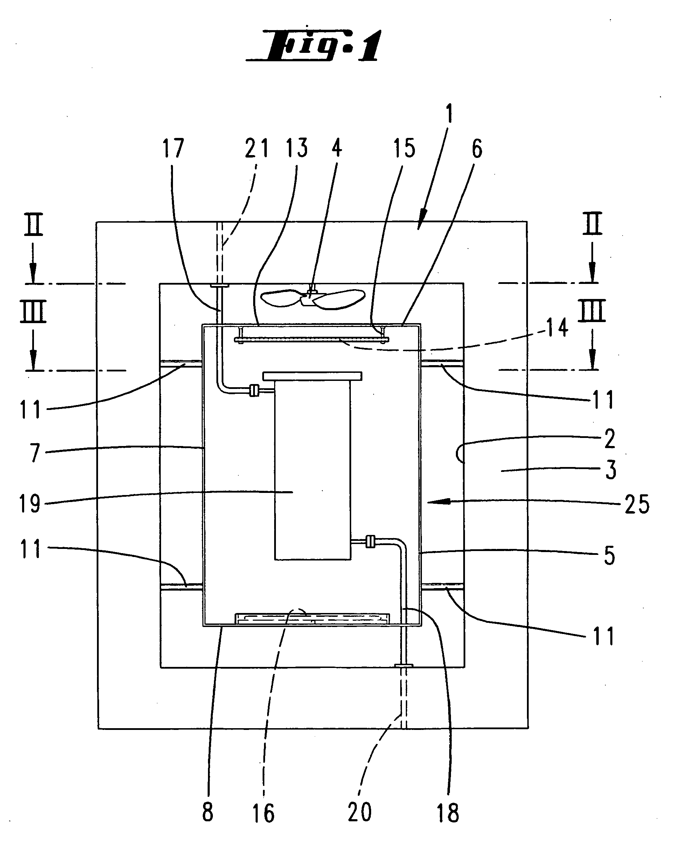

- Fig.1: in schematischer Darstellung einen Blick durch die Türöffnung einer Vorrichtung zur temperierten Aufbewahrung eines Behälters, wobei die Frontwand des Innengehäuses weggelassen ist,

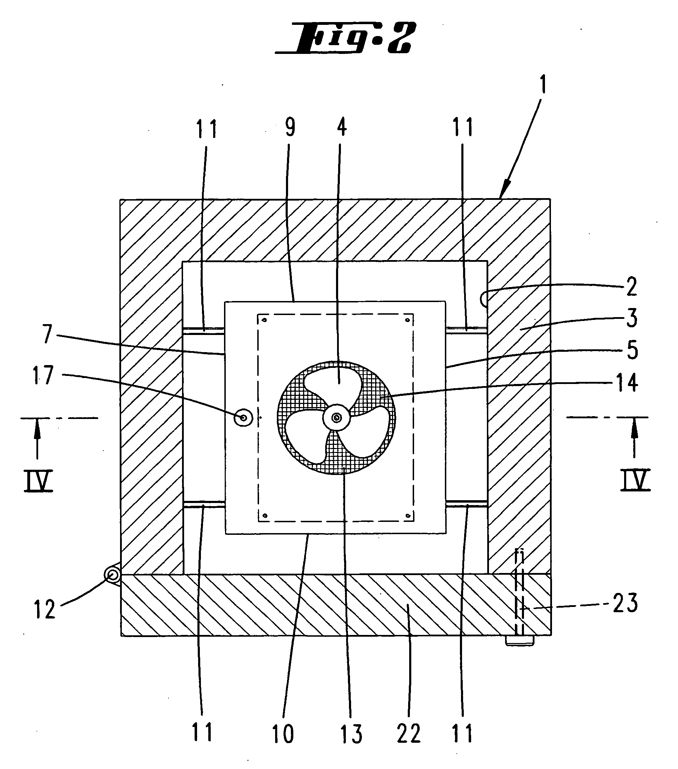

- Fig. 2: einen Schnitt gemäß der Linie II - II in Fig. 1,

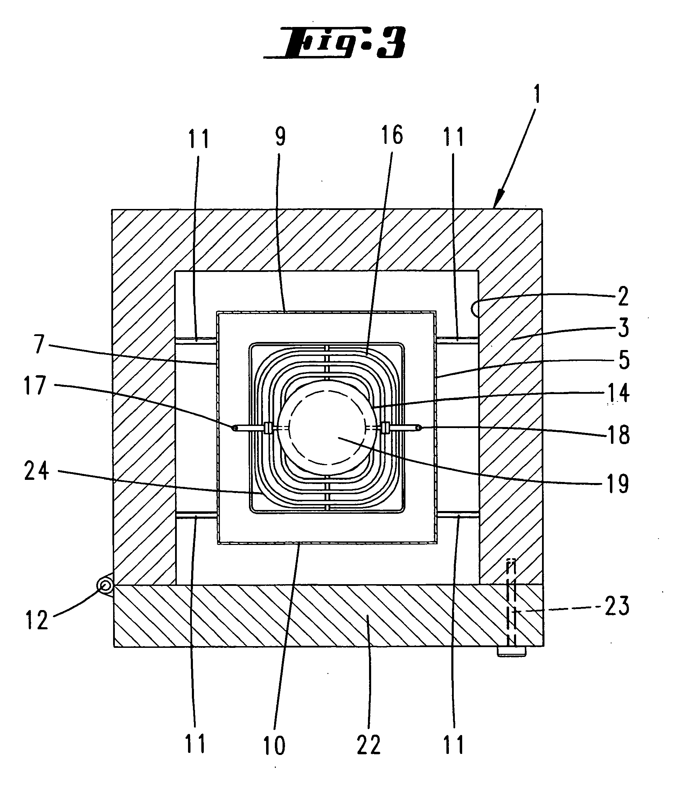

- Fig. 3: einen Schnitt gemäß der Linie III - III in Fig. 1 und

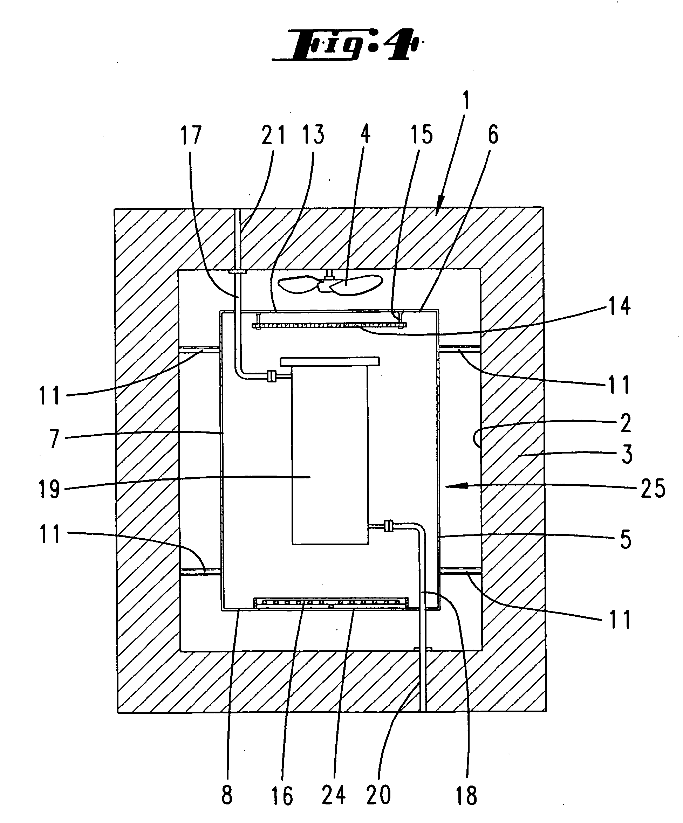

- Fig. 4: einen Schnitt gemäß der Linie IV - IV in Fig. 2.

Das Gehäuse 1, welches eine Kammer 25 umgibt, besitzt thermisch isolierende Wände 3 und eine eine Türöffnung verschließende Tür 22, die am Gehäuse mittels eines Scharniers 12 angelenkt ist und die mit einem Bolzen 23 verschließbar ist, wobei die Tür die Kammer 25 gasdicht und wärmeisolierend verschließt.

Die obere Kammerwand besitzt eine Durchgangsöffnung 21 für eine Zuleitung 17, durch die ein Trägergas in einen in der Kammer 25 angeordneten Behälter 19 strömt, in welcher sich in die Gasform zu verbringende flüssige oder feste, pulver- oder granulatförmige Substanz befindet, die zusammen mit dem Trägergas durch eine Ableitung 18 abgeleitet wird, welche Ableitung 18 eine Durchgangsöffnung 20 im Bodenbereich der Gehäusewandung durchgreift.

Die Kammer 25 ist nach außen hin thermisch isoliert. Innerhalb der quaderförmigen Kammer 25 befindet sich ein quaderförmiges Innengehäuse, welches aus Seitenwänden 5, 7, 9, 10 besteht, die miteinander verschraubt oder verschweißt sind. Zusätzlich ist eine Deckenplatte 6 mit einer Öffnung 13 und eine Bodenplatte 8 mit einer Öffnung 24 vorgesehen. Dieses aus den Teilen 5-10 bestehende Innengehäuse ist mittels Befestigungsstegen 11 innerhalb des Gehäuses 1 derartig befestigt, dass die Wände 5-10 des Innengehäuses einen gleichen Abstand zur Gehäuseinnenwand 2 aufweisen. Hierzu erstrecken sich die Befestigungsstege 11 von der Gehäuseinnenwand 2 zu den beiden sich gegenüberliegenden Seitenwänden 5 und 7.

Oberhalb der Öffnung 13 der Decke 6 befindet sich ein elektrisch angetriebener Ventilator 4, welcher das Gas, welches Luft sein kann, durch die Öffnung 13 aus dem Innengehäuse heraussaugt. Unterhalb der Öffnung 13 befindet sich ein Gitter 14, welches mittels Abstandshalter 15 von der Decke 6 des Innengehäuses beabstandet ist. Oberhalb des Bodens 8 befindet sich eine elektrische Widerstandsheizung 16. Es handelt sich hierbei um ein Heizregister, welches oberhalb der Bodenöffnung 24 angeordnet ist. Zwischen der Heizung 16 und dem Ventilator 4, also zwischen den beiden Öffnungen 13 und 24 befindet sich der Behälter 19.

Wird der Ventilator 4 in Betrieb gesetzt, so saugt er Gas, welches Luft sein kann, durch die Öffnung 13 an. Er verteilt dieses angesaugte Gas radial, so dass es zwischen den Wandungen des Innengehäuses 5-10 und der Gehäuseinnenwandung 2 entlangströmt. Es tritt dann durch die Öffnung 24 wieder in das Innengehäuse hinein und wird durch die Heizung 16 aufgeheizt. Durch die entgegengesetzten Ströme an den Wandungsseiten der Wände 5-10, oder durch Konvektionsmischung gleicht sich deren Temperatur aus. Dazu unterstützt die konvektive Mischung den Temperaturausgleich. Es wird die erforderliche Temperaturstabilität erzeugt. Wesentlich sind die zwei Ofenbereiche, nämlich der Innenbereich und der Außenbereich, wobei im Innenbereich der Behälter und im Außenbereich lediglich ein Luftstrom vorhanden ist.

## Patentansprüche

1. Vorrichtung zur temperierten Aufbewahrung eines Behälters (19) zur Aufnahme kondensierter Stoffe, die durch Verdampfen mittels eines durch den Behälter geleiteten Trägergases aus dem Behälter (19) transportiert werden, mit einem eine Kammer (25) ausbildenden Gehäuse (3), dessen Gehäusewand (2) wärmeisolierend ausgebildet ist, mit einem Durchgang (20, 21) in der Gehäusewand (2) für eine Gaszu- bzw. -ableitung (17, 18) zu dem bzw. von dem in der Kammer angeordneten Behälter (19) und mit einer Heizung (16) oder Kühlung zur Temperierung der Kammer (25), **dadurch gekennzeichnet, dass** in der Kammer (25) ein Gasstromerzeuger (4) für Heizung (16) bzw. Kühlung und den vom Gasstromerzeuger (4) erzeugten Gasstrom leitende Gasstromleitmittel (5-10) vorgesehen sind, welche die Wände eines den Behälter (19) aufnehmenden Innengehäuses ausbilden, an denen der Gasstrom beidseitig und jeweils in entgegengesetzter Richtung vorbeiströmt.

2. Vorrichtung nach Anspruch 1, **dadurch gekennzeichnet, dass** der vom Gasstromerzeuger erzeugte und von den Gasstromleitmitteln (5-10) geleitete Gasstrom von der Heizung (16) erwärmt wird und an dem Behälter (19) entlangströmt.

3. Vorrichtung nach einem der vorhergehenden Ansprüche, **dadurch gekennzeichnet, dass** der vom Gasstromerzeuger (4) erzeugte und von den Gasstromleitmitteln (5-10) geleitete Gasstrom an der Gehäusewand (2) entlangströmt.

4. Vorrichtung nach einem der vorhergehenden Ansprüche, **dadurch gekennzeichnet, dass** die Gasstromleitmittel (5-10) die Wände (5-10) des Innengehäuses ausbilden und einen im Wesentlichen gleichen Abstand zur Gehäuseinnenwandung (2) besitzen.

5. Vorrichtung nach einem der vorhergehenden Ansprüche, **gekennzeichnet durch** ein unterhalb des Behälters (19) angeordnetes Heizregister (16) zur Erwärmung des in der Kammer (25) strömenden Gases.

6. Vorrichtung nach einem der vorhergehenden Ansprüche, **dadurch gekennzeichnet, dass** das Gas Luft oder Stickstoff ist.

7. Vorrichtung nach einem der vorhergehenden Ansprüche, **dadurch gekennzeichnet, dass** die Gasstromleitmittel (5-10) aus Blech bestehen.

8. Vorrichtung nach einem der vorhergehenden Ansprüche, **dadurch gekennzeichnet, dass** das von den Gasstromleitmitteln (5-10) ausgebildete Innengehäuse deckenseitig und bodenseitig eine Durchströmöffnung (13, 24) aufweist.

9. Vorrichtung nach einem der vorhergehenden Ansprüche, **dadurch gekennzeichnet, dass** die zum Behälter (19) bzw. zur Gehäuseinnenwandung (2) weisenden Oberflächen der Gasstromleitmittel (5-10) definierte und insbesondere Wärmestrahlungseigenschaften besitzen.

10. Vorrichtung nach einem der vorhergehenden Ansprüche, **dadurch gekennzeichnet, dass** die Oberflächen der Gasstromleitmittel (5-10) glänzend, fein rauh oder grob rauh sind.

11. Vorrichtung nach einem der vorhergehenden Ansprüche, **dadurch gekennzeichnet, dass** die Heizung (16) eine Widerstandsheizung ist und oberhalb einer bodenseitigen Öffnung (24) einer bodenseitigen Wandung (8) eines Innengehäuses angeordnet ist.

12. Vorrichtung nach einem der vorhergehenden Ansprüche, **dadurch gekennzeichnet, dass** der Gasstromerzeuger (4) ein an der Decke des Gehäuses (1) angeordneter Ventilator ist, unter welchem sich eine Öffnung (13) einer Decke (6) des Innengehäuses befindet.

13. Vorrichtung nach einem der vorhergehenden Ansprüche, **dadurch gekennzeichnet, dass** der Gasstrom das Innengehäuse (5-10) von unten nach oben durchströmt.

14. Vorrichtung nach einem der vorhergehenden Ansprüche, **gekennzeichnet durch** die Seitenwandungen (5, 7) des Innengehäuses mit Abstand zu der Gehäuseinnenwandung (2) haltende Befestigungsstege (11).

15. Vorrichtung nach einem der vorhergehenden Ansprüche, **dadurch gekennzeichnet, dass** das Gehäuse eine Tür (22) aufweist, die von einem insbesondere als Schraube ausgebildeten Verschluss gegen die Öffnung des Gehäuses (3) gepresst wird und die Kammer (25) gasdicht und wärmeisolierend verschließt.

16. Vorrichtung zum Abscheiden insbesondere organischer Schichten, bei dem in einem beheizten Reaktor ein in einer von einem Behälter gebildeten Quelle bevorrateter, nicht gasförmiger Ausgangsstoff mittels eines Trägergases im gasförmigen Zustand von der Quelle zu einem Substrat transportiert wird, wo er auf dem Substrat deponiert, **dadurch gekennzeichnet, dass** die Quelle in einer Vorrichtung gemäß einem der vorhergehenden Ansprüche angeordnet ist.

## Claims

1. Device for the temperature-controlled accommodation of a container (19) for receiving condensed materials, which are transported out of the container (19) by evaporation by means of a carrier gas passed through the container, comprising a housing (3) forming a chamber (25), the housing wall (2) of which is formed in a heat-insulating manner, comprising a passage (20, 21) in the housing wall (2) for a gas supply line (17) or a gas discharge line (18) to or from the container (19) disposed in the chamber and comprising a heater (16) or a cooling system for controlling the temperature of the chamber (25), **characterized in that** a gas flow producer (4), for heating (16) or cooling, and gas flow directing means (5-10), which direct the gas flow produced by the gas flow producer (4), are provided in the chamber (25), which gas flow directing means form the walls of an internal housing accommodating the container (19), on which the gas flow flows past on both sides in respectively opposed directions,

2. Device according to Claim 1, **characterized in that** the gas flow produced by the gas flow producer and directed by the gas flow directing means (5-10) is heated by the heater (16) and flows along on the container (19).

3. Device according to one of the preceding claims, **characterized in that** the gas flow produced by the gas flow producer (4) and directed by the gas flow directing means (5-10) flows along on the housing wall (2).

4. Device according to one of the preceding claims, **characterized in that** the gas flow directing means (5-10) form the walls (5-10) of the internal housing and are at a substantially uniform spacing from the inner wall (2) of the housing.

5. Device according to one of the preceding claims, **characterized by** a heating register (16), disposed underneath the container (19), for heating the gas flowing into the chamber (25).

6. Device according to one of the preceding claims, **characterized in that** the gas is air or nitrogen.

7. Device according to one of the preceding claims, **characterized in that** the gas flow directing means (5-10) consist of metal plate.

8. Device according to one of the preceding claims, **characterized in that** the internal housing formed by the gas flow directing means (5-10) has a through-flow opening (13, 24) in the ceiling and in the floor.

9. Device according to one of the preceding claims, **characterized in that** the surfaces of the gas flow directing means (5-10) that are facing the container (19) and the inner wall (2) of the housing have defined and in particular heat radiating properties.

10. Device according to one of the preceding claims, **characterized in that** the surfaces of the gas flow directing means (5-10) are bright, finely rough or coarsely rough.

11. Device according to one of the preceding claims, **characterized in that** the heater (16) is a resistance heater and is disposed above a bottom opening (24) in a wall (8), forming the floor, of an internal housing.

12. Device according to one of the preceding claims, **characterized in that** the gas flow producer (4) is a fan disposed on the ceiling of the housing (1), under which there is an opening (13) in a ceiling (6) of the internal housing.

13. Device according to one of the preceding claims, **characterized in that** the gas flow flows through the internal housing (5-10) from bottom to top.

14. Device according to one of the preceding claims, **characterized by** mounting members (11) keeping the side walls (5, 7) of the internal housing at a spacing from the inner wall (2) of the housing.

15. Device according to one of the preceding claims, **characterized in that** the housing has a door (22), which is pressed by a closure, formed in particular as a bolt, against the opening of the housing (3) and seals the chamber (25) in a gas-tight and heat-insulating manner.

16. Device for depositing layers, in particular organic layers, in which, in a heated reactor, a non-gaseous starting material stored in a source formed by a container is transported by means of a carrier gas in a gaseous state from the source to a substrate, where it is deposited on the substrate, **characterized in that** the source is disposed in a device according to one of the preceding claims.

## Revendications

1. Dispositif pour le stockage thermorégulé d'un récipient (19) destiné à recevoir des matières condensées qui sont transportées à l'extérieur du récipient (19) par vaporisation à l'aide d'un gaz porteur que l'on fait passer à travers le récipient, le dispositif comportant un boîtier (3) formant une chambre (25) et dont la paroi (2) est conformée pour être thermiquement isolante, un passage (20, 21) ménagé dans la paroi (2) du boîtier et destiné à une conduite (17, 18) d'amenée, respectivement d'évacuation, de gaz vers, respectivement depuis, le récipient (19) disposé dans la chambre, et un dispositif de chauffage (16) ou de refroidissement pour la thermorégulation de la chambre (25), **caractérisé en ce qu'**il est prévu dans la chambre (25) un générateur de flux de gaz (4) pour le chauffage (16), respectivement le refroidissement, et des moyens de transport de flux de gaz (5-10), qui transportent le flux de gaz généré par le générateur de flux de gaz (4) et qui forment les parois d'un boîtier intérieur recevant le récipient (19) et le long desquelles le flux de gaz s'écoule de chaque côté dans des directions opposées.

2. Dispositif selon la revendication 1, **caractérisé en ce que** le flux de gaz, généré par le générateur de flux de gaz et transporté par les moyens de transport de flux de gaz (5-10), est chauffé par le dispositif de chauffage (16) et s'écoule le long du récipient (19).

3. Dispositif selon l'une des revendications précédentes, **caractérisé en ce que** le flux de gaz, généré par le générateur de flux de gaz (4) et transporté par les moyens de transport de flux de gaz (5-10), s'écoule le long de la paroi de boîtier (2).

4. Dispositif selon l'une des revendications précédentes, **caractérisé en ce que** les moyens de transport de flux de gaz (5-10) forment les parois (5-10) du boîtier intérieur et se trouvent à une distance sensiblement constante de la paroi intérieure du boîtier (2).

5. Dispositif selon l'une des revendications précédentes, **caractérisé par** un échangeur thermique (16), disposé au-dessous du récipient (19) pour chauffer le gaz s'écoulant dans la chambre (25).

6. Dispositif selon l'une des revendications précédentes, **caractérisé en ce que** le gaz est de l'air ou de l'azote.

7. Dispositif selon l'une des revendications précédentes, **caractérisé en ce que** les moyens de transport de flux de gaz (5-10) sont en tôle.

8. Dispositif selon l'une des revendications précédentes, **caractérisé en ce que** le boîtier intérieur formé par les moyens de transport de flux de gaz (5-10) comporte côté fond et côté couvercle une ouverture d'écoulement (13, 24).

9. Dispositif selon l'une des revendications précédentes, **caractérisé en ce que** les surfaces des moyens de transport de flux de gaz (5-10) qui sont dirigées vers le récipient (19), respectivement vers la paroi intérieure de boîtier (2), possèdent des propriétés définies, notamment de rayonnement thermique.

10. Dispositif selon l'une des revendications précédentes, **caractérisé en ce que** les surfaces des moyens de transport de flux de gaz (5-10) sont brillantes, finement rugueuses ou grossièrement rugueuses.

11. Dispositif selon l'une des revendications précédentes, **caractérisé en ce que** le dispositif de chauffage (16) est un dispositif de chauffage à résistance et est disposé au-dessus d'une ouverture côté fond (24) d'une paroi de fond (8) d'un boîtier intérieur.

12. Dispositif selon l'une des revendications précédentes, **caractérisé en ce que** le générateur de flux de gaz (4) est un ventilateur qui est disposé au niveau du couvercle du boîtier (1) et sous lequel se trouve une ouverture (13) ménagée dans un couvercle (6) du boîtier intérieur.

13. Dispositif selon l'une des revendications précédentes, **caractérisé en ce que** le flux de gaz s'écoule à travers le boîtier intérieur (5-10) du bas vers le haut.

14. Dispositif selon l'une des revendications précédentes, **caractérisé par** des nervures de fixation (11) qui maintiennent les parois latérales (5, 7) du boîtier intérieur à distance de la paroi intérieure (2) du boîtier.

15. Dispositif selon l'une des revendications précédentes, **caractérisé en ce que** le boîtier comporte une porte (22) qui est pressée contre l'ouverture du boîtier (3) par un dispositif de fermeture conformé notamment en vis et qui ferme la chambre (25) de façon étanche au gaz et thermiquement isolante.

16. Dispositif de dépôt de couches, notamment organiques, dans lequel, dans un réacteur chauffé, une substance de départ non gazeuse, provenant d'une source formée par un récipient, est transportée à l'état gazeux, au moyen d'un gaz porteur, de la source à un substrat où elle est déposée sur le substrat, **caractérisé en ce que** la source est disposée dans un dispositif selon l'une des revendications précédentes.
